# FASCICULE DE BREVET EUROPEEN

(11) **EP 1 636 399 B1**
(45) Date de publication et mention de la délivrance du brevet: **02.03.2011**
(21) Numéro de dépôt: 04767349.6
(22) Date de dépôt: 15.06.2004
(51) Int. Cl.: C23C 16/26, C23C 16/02, C23C 16/32, C23C 16/50

(54) **REVETEMENT POUR UNE PIECE MECANIQUE COMPRENANT AU MOINS UNE COUCHE EXTERNE DE CARBONE AMORPHE HYDROGENE ET UNE COUCHE DE CARBURE DE SILICIUM HYDROGENE EN CONTACT AVEC LA PIECE, ET PROCEDE DE DEPOT D'UN TEL REVETEMENT**
ÜBERZUG FÜR MECHANISCHES TEIL, UMFASSEND MINDESTENS EINEN HYDRIERTEN AMORPHEN KOHLENSTOFF, UND VERFAHREN ZUR ABSCHEIDUNG EINES DERARTIGEN ÜBERZUGS
COATING FOR A MECHANICAL PART, COMPRISING AT LEAST ONE HYDROGENATED AMORPHOUS CARBON, AND METHOD OF DEPOSITING ONE SUCH COATING

(30) Priorité: 16.06.2003 FR 0307221
(43) Date de publication de la demande: 22.03.2006
(73) Titulaire: Commissariat à l'Énergie Atomique et aux Énergies Alternatives, 75015 Paris (FR)
(72) Inventeur: PLISSONNIER, Marc, 38320 Eybens (FR); GAILLARD, Frédéric, 38500 Voiron (FR); THOLLON, Stéphanie, 38250 Saint-Nizier-du-Moucherotte (FR)
(74) Mandataire: Hecké, Gérard
(86) Numéro de dépôt international: PCT/FR2004/001486
(87) Numéro de publication internationale: WO 2004/113586

(56) Documents cités:
- WO-A-00/47290
- US-A- 5 900 289

## Description

### Domaine technique de l'invention

L'invention concerne un revêtement pour une pièce mécanique comprenant au moins une couche externe en carbone amorphe hydrogéné.

### État de la technique

Pour améliorer la résistance à l'usure et aux frottements de pièces mécaniques, il est possible de les revêtir d'un film en carbone amorphe hydrogéné, également appelé DLC (« Diamond Like Carbon »). Le carbone amorphe hydrogéné présente, en effet, une très grande dureté, un module d'Young élevé et les coefficients de frottement et d'usure sont extrêmement bas. De plus, le film en carbone amorphe hydrogéné est très peu rugueux et très peu poreux et il a une énergie de surface basse.

Cependant, le film en carbone amorphe hydrogéné présente des contraintes intrinsèques très élevées, de l'ordre de plusieurs GPa. Ces contraintes élevées pouvant détériorer l'adhésion du film sur une pièce mécanique, notamment en acier, elles ne permettent pas de réaliser des dépôts de plus de 5 micromètres d'épaisseur. De plus, le carbone amorphe hydrogéné a une stabilité thermique relativement faible, ce qui empêche d'utiliser un revêtement en DLC pour des températures supérieures à 250°C. Le coefficient de friction du DLC augmente également en fonction du taux d'humidité dans l'atmosphère. À titre d'exemple, le coefficient de friction d'un film de carbone amorphe hydrogéné déposé sur de l'acier augmente graduellement de 0,05 dans une atmosphère sèche jusqu'à 0,3 dans une atmosphère à 100% d'humidité.

Certains ont tenté d'améliorer les propriétés du DLC en le dopant avec des éléments métalliques ou non métalliques. Ainsi, l'ajout de 10 à 20% atomique de silicium dans du carbone amorphe hydrogéné permet de diminuer les contraintes internes jusqu'à une valeur proche de 1 GPa, sans toutefois augmenter significativement le coefficient de frottement. De plus, l'ajout de silicium augmente la stabilité thermique du film de DLC tout en diminuant la dépendance du coefficient de friction par rapport au taux d'humidité.

La demande de brevet WO-A-00/47290 propose d'ajouter des atomes de silicium dans une couche en DLC de manière à modifier la couleur du revêtement, en diluant la concentration du carbone. Ainsi, un revêtement décoratif composite pour substrat métallique, d'une épaisseur totale comprise entre 1 et 25 µm comporte au moins une première couche d'une épaisseur de 0,1 à 15 µm, en carbone amorphe hydrogéné dopé par du silicium dans une proportion de 2 à 40% atomique. Le revêtement peut également comporter une couche additionnelle comprenant des couches en carbone amorphe hydrogéné dopé par du silicium et en carbone amorphe hydrogéné, d'une épaisseur supérieure ou égale à 0,5 µm. La couche en carbone amorphe hydrogéné dopé par du silicium a, cependant, une structure proche de celle du carbone amorphe hydrogéné, la présence des atomes de silicium dans le DLC provoquant la formation de liaisons Si-H destinées à limiter la formation des liaisons C-C de type sp² par rapport aux liaisons C-C de type sp³.

De même, l'ajout d'un dopant métallique comme le tantale, le tungstène, le titane, le niobium ou le zirconium permet de diminuer les contraintes intrinsèques et la dépendance du coefficient de friction par rapport au taux d'humidité. L'ajout de silicium, de bore, de fluor, d'oxygène ou d'azote permet également d'influencer l'énergie de surface.

Il est également possible de palier les défauts du carbone amorphe hydrogéné non dopé, en réalisant un dépôt d'un matériau composite constitué de carbone amorphe hydrogéné et d'oxyde de silicium amorphe. Le matériau composite a des contraintes intrinsèques réduites par rapport au carbone amorphe hydrogéné seul, ce qui permet d'obtenir une meilleure adhésion du film sur de nombreux matériaux constituant la pièce à protéger. De plus, la stabilité thermique est améliorée et le coefficient de friction est réduit. Cependant, la dureté du matériau composite est inférieure à celle du carbone amorphe hydrogéné seul.

Ce type de revêtement n'est cependant pas facile à mettre en oeuvre, notamment pour des pièces mécaniques ayant une forme complexe. Les contraintes intrinsèques du carbone amorphe hydrogéné étant élevées, des revêtements d'une épaisseur supérieure à 5 micromètres ne sont pas réalisables, ce qui peut limiter les performances des revêtements. De plus, la réalisation d'un dépôt en carbone amorphe hydrogéné, dopé ou non dopé ou d'un dépôt constitué par un matériau composite comportant du carbone amorphe hydrogéné, ne peut pas être réalisée à basse température. La mise en oeuvre d'un tel dépôt peut également être longue et coûteuse, et ce, pour obtenir des propriétés d'anti-usure, d'anti-frottement et de stabilité thermique, qui peuvent être peu satisfaisantes dans certains types d'application.

### Objet de l'invention

L'invention a pour but de réaliser un revêtement apte à adhérer parfaitement sur une pièce mécanique pouvant avoir tout type de forme, capable d'être stable thermiquement à des températures élevées, de préférence supérieures à 250°C, et ayant, notamment, des propriétés anti-usure et anti-frottement élevées.

Selon l'invention, ce but est atteint par le fait que le revêtement est constitué par une première couche en carbure de silicium amorphe hydrogéné destinée à être en contact avec la pièce mécanique, un empilement constitué par une alternance de couches respectivement en carbone amorphe hydrogéné et en carbure de silicium amorphe hydrogéné étant disposé entre la première couche et la couche externe.

Selon un développement de l'invention, l'épaisseur totale du revêtement est comprise entre 10 et 20 micromètres.

Selon un mode de réalisation préférentiel, l'épaisseur de la première couche est comprise entre 150 et 300 nanomètres.

Selon une autre caractéristique de l'invention, l'épaisseur de la couche externe est comprise entre 0,5 et 2 micromètres.

L'invention a également pour but un procédé de dépôt d'un revêtement pour une pièce mécanique, facile à mettre en oeuvre, peu coûteux et pouvant être réalisé à basse température.

Selon l'invention, ce but est atteint par le fait que le procédé consiste à déposer, successivement, dans une même enceinte de dépôt chimique en phase vapeur assisté par plasma :
- une première couche en carbure de silicium amorphe hydrogéné,
- une alternance de couches respectivement en carbone amorphe hydrogéné et en carbure de silicium amorphe hydrogéné,
- et une couche externe en carbone amorphe hydrogéné.

### Description sommaire des dessins

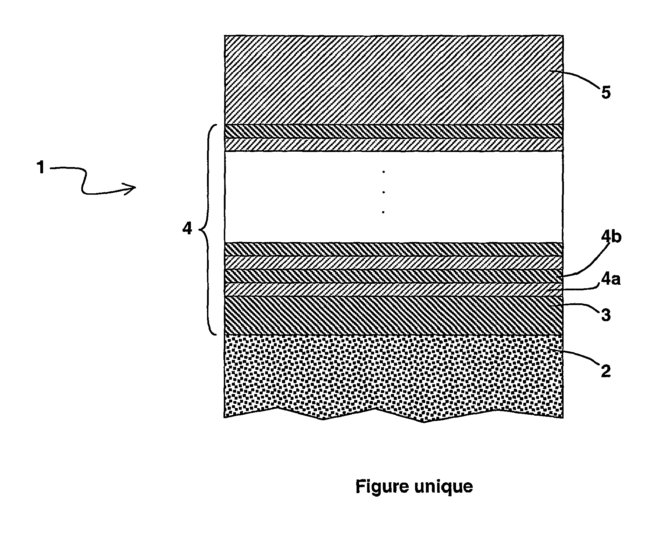

D'autres avantages et caractéristiques ressortiront plus clairement de la description qui va suivre de modes particuliers de réalisation de l'invention donnés à titre d'exemples non limitatifs et représenté à la figure unique annexée.

La figure unique est une représentation schématique, en coupe, d'un revêtement pour une pièce mécanique selon l'invention.

### Description de modes particuliers de réalisation.

Comme représenté à la figure unique, un revêtement 1, ayant, de préférence, une épaisseur totale comprise entre 10 et 20 micromètres, est déposé sur une pièce mécanique 2 de manière à protéger la surface de la pièce 2 contre l'usure et contre les frottements. Le revêtement 1 comporte une première couche 3 en carbure de silicium amorphe hydrogéné, un empilement de couches 4 et une couche externe 5 en carbone amorphe hydrogéné (DLC). La première couche 3 est disposée sur la surface de la pièce mécanique 2 et a, de préférence, une épaisseur comprise entre 150 et 300 nanomètres tandis que la couche externe 5 en carbone amorphe hydrogéné a une épaisseur comprise entre 0,5 et 2 micromètres. Par carbure de silicium amorphe hydrogéné, également noté SiC :H ou a-Si₁₋ₓCₓ :H, x étant, de préférence, de l'ordre de 0,5, on entend un composé amorphe de carbure de silicium dans lequel est incorporée une proportion en hydrogène plus faible que les proportions en silicium et en carbone. Un tel composé ne comporte pas de liaison de type C-C mais uniquement des liaisons de type Si-C, Si-H et C-H.

L'empilement 4 est constitué par une alternance de deux couches 4a et 4b, respectivement en carbone amorphe hydrogéné (DLC) et en carbure de silicium amorphe hydrogéné (SiC :H ou a-Si₁₋ₓCₓ). Dans l'empilement 4, chaque couche 4a en carbone amorphe hydrogéné a, de préférence, une épaisseur comprise entre 10 et 150 nanomètres tandis que chaque couche 4b en carbure de silicium amorphe hydrogéné a, de préférence, une épaisseur comprise entre 5 et 50 nanomètres. L'empilement comporte, ainsi, un très grand nombre de couches, qui est, de préférence, compris entre 400 et 1000.

Un tel revêtement permet, grâce à son épaisseur et sa structure, d'obtenir des performances mécaniques très élevées et notamment des résistances à l'usure et aux frottements très importantes par rapport à un revêtement ne comportant qu'une seule couche en carbone amorphe hydrogéné. De plus, le carbure de silicium amorphe hydrogéné est connu comme isolant thermique. Ainsi, les couches 4b et 2, en carbure de silicium amorphe hydrogéné, permettent de protéger thermiquement les couches adjacentes 4a et 5, en carbone amorphe hydrogéné, qui sont peu stables thermiquement pour des températures supérieures à 250°C.

Un tel revêtement peut donc être déposé sur une pièce mécanique destinée à être soumise à des températures supérieures à 250°C, comme les pistons de moteur par exemple et notamment ceux utilisés en Formule 1. Le carbure de silicium amorphe permet également d'améliorer l'adhésion du revêtement sur la pièce mécanique et les couches constituant le revêtement sont particulièrement denses, homogènes et adhérentes entre elles.

Un tel revêtement présente également l'avantage d'être facilement et rapidement mis en oeuvre. Ainsi, pour réaliser le dépôt d'un tel revêtement sur une pièce mécanique, les couches sont, de préférence, déposées successivement par un même procédé de dépôt chimique en phase vapeur assisté par plasma (« Plasma Enhanced Chemical Vapour Deposition » ou « PECVD »), dans une même enceinte et de préférence à basse fréquence. Ceci permet notamment de réaliser des dépôts sur des pièces mécaniques ayant des dimensions importantes et/ou de géométrie complexe.

Ainsi, dans un mode particulier de réalisation, la pièce mécanique dont la surface est destinée à être protégée, est, préalablement, nettoyée et disposée dans une enceinte de dépôt chimique en phase vapeur assisté par plasma. La surface de la pièce mécanique subit ensuite un décapage ionique, consistant à ioniser un gaz inerte tel que l'argon pour former des ions positifs destinés à être bombardés à la surface de la pièce pour la décaper. La première couche en carbure de silicium amorphe hydrogéné est déposée, sous vide, par un dépôt PECVD, ainsi que les couches formant l'empilement et la couche externe en carbone amorphe hydrogéné. Ainsi, le vide limite atteint avant le dépôt de la première couche est de l'ordre de 10⁻³mbars et la pression dans l'enceinte pendant le dépôt des couches est comprise entre 0,05mbars et 0,5mbars. Le dépôt PECVD successif des différentes couches est, de préférence, commandé et contrôlé pour tout type de moyens informatiques connus, de sorte que l'épaisseur de chaque couche puisse être contrôlée.

Les couches en carbure de silicium amorphe hydrogéné sont, de préférence, réalisées par dépôt PECVD, en utilisant, comme précurseur, du tétraméthylsilane (Si(CH₃)₄) dilué dans de l'hydrogène ou un mélange de gaz comprenant du silane et du méthane (SiH₄ et CH₃). L'utilisation de tels précurseurs permet, en effet, d'obtenir un composé stoechiométrique de carbure de silicium amorphe hydrogéné (a-Si₁₋ₓCₓ :H avec x = 0,5). Comme indiqué dans l'article de J.Huran ("Properties of amorphous silicon carbide films prepared by PECVD", Vacuum, Vol 47, n°10, pages 1223 à 1225/1996), un tel composé ne possède que des liaisons covalentes Si-C, C-H et Si-H, déjà présentes dans le précurseur et donc aucune liaison C-C. Le carbure de silicium amorphe hydrogéné ne doit, donc, pas être confondu structurellement avec un carbone amorphe hydrogéné dopé par du silicium, comportant, notamment des liaisons C-C de type sp² et sp³.

Le fait de réaliser successivement le dépôt des différentes couches du revêtement dans une même enceinte PECVD permet de réaliser le revêtement par un même procédé de dépôt et à basse température. Ceci permet de maîtriser la qualité des interfaces entre deux couches adjacentes et de réaliser des dépôts de couches ayant une épaisseur très faible. De plus, cela permet de réaliser une alternance parfaite de couches en carbone amorphe hydrogéné et en carbure de silicium amorphe hydrogéné.

À titre d'exemple, des premier et second revêtements A et B ont été réalisés par un tel procédé de dépôt.

Ainsi, un premier revêtement A comporte une première couche 3 en SiC :H d'une épaisseur de 225nm, un empilement 4 comportant une alternance de 240 couches en DLC et de 240 couches en SiC :H et une couche externe 5 en DLC d'une épaisseur de 1 micromètre. Dans l'empilement 4, chacune des couches en DLC de l'empilement a une épaisseur de 150 nm, tandis que chacune des couches en SiC :H a une épaisseur de 50nm.

Un second revêtement B comporte une première couche 3 en SiC :H d'une épaisseur de 195nm, l'empilement 4 comporte une alternance de 490 couches en DLC et de 490 couches en SiC :H et la couche externe 5 en DLC a une épaisseur de 1 micromètre. Dans l'empilement 4, chacune des couches en DLC de l'empilement a une épaisseur de 15 nm, tandis que chacune des couches en SiC :H a une épaisseur de 5nm.

Les résultats d'essais mécaniques réalisés sur les premier et second revêtements A et B, ainsi que sur un revêtement C_{ref} comportant uniquement une couche en carbone amorphe hydrogéné de 2 micromètres d'épaisseur sont résumés dans le tableau ci-dessous :

| | **Tests tribologiques** Vᵤ = volume d'usure en mm³.N⁻¹.N⁻¹.m⁻¹ µ = coefficient de friction | | **Tests de Nanoindentation** | |
|---|---|---|---|---|
| **Revêtement** | **Atmosphère sèche** | **Atmosphère humide** | **Microdureté** H (MPa) | E (GPa) |
| A | µ=0,053 | µ=0,094 | 20000 | 180 |
| | Vᵤ=2.10⁻⁶ | Vᵤ=7.10⁻⁷ | | |
| B | µ=0,038 | µ=0,088 | 18000 | 140 |
| | vᵤ=8.10⁻⁶ | Vᵤ=5.10⁻⁷ | | |
| C_{ref} | µ=0,063 | µ=0,122 | 21000 | 190 |
| | vᵤ=4.10⁻⁸ | Vᵤ=2.10⁻⁵ | | |

Le volume d'usure Vᵤ est mesuré par profilométrie.

On observe que la microdureté des revêtements A et B est légèrement plus faible que celle du revêtement C_{ref} en DLC mais les revêtements A et B présentent un bon compromis entre une bonne microdureté et un faible coefficient de friction sous atmosphère sèche et sous atmosphère humide, contrairement au revêtement C_{ref} qui présente un coefficient de friction variant fortement en fonction du taux d'humidité.

Jusqu'à présent, l'application industrielle du carbone amorphe hydrogéné en tant que revêtement était limitée par le trop grand compromis devant être fait entre le coefficient de friction et la microdureté. Le revêtement selon l'invention permet donc de palier à cet inconvénient en garantissant à la fois un faible coefficient de friction et une bonne microdureté. De plus, le comportement des revêtements A et B, sous atmosphère humide est meilleur que celui du revêtement C_{ref}.

Un tel revêtement constitué d'un empilement successif de couches respectivement en carbure de silicium amorphe hydrogéné et en carbone amorphe hydrogéné est comparable à une superposition de feuillets de très faible épaisseur en carbure de silicium amorphe hydrogéné et en carbone amorphe hydrogéné, permet d'obtenir une très bonne adhésion sur une pièce mécanique, des caractéristiques anti-usure et anti-frottement améliorées et une bonne stabilité thermique à des températures élevées.

## Revendications

1. Revêtement pour une pièce mécanique comprenant au moins une couche externe (5) en carbone amorphe hydrogéné, **caractérisé en ce que** le revêtement (1) est constitué par une première couche (3) en carbure de silicium amorphe hydrogéné destinée à être en contact avec la pièce mécanique (2), un empilement (4) constitué par une alternance de couches (4a, 4b) respectivement en carbone amorphe hydrogéné et en carbure de silicium amorphe hydrogéné étant disposé entre la première couche (3) et la couche externe (5).

2. Revêtement selon la revendication 1, **caractérisé en ce que** l'épaisseur totale du revêtement (1) est comprise entre 10 et 20 micromètres.

3. Revêtement selon l'une des revendications 1 et 2, **caractérisé en ce que** l'épaisseur de la première couche (3) est comprise entre 150 et 300 nanomètres.

4. Revêtement selon l'une quelconque des revendications 1 à 3, **caractérisé en ce que** l'épaisseur de la couche externe (5) est comprise entre 0,5 et 2 micromètres.

5. Revêtement selon l'une quelconque des revendications 1 à 4, **caractérisé en ce que** l'épaisseur de chacune des couches (4b) en carbure de silicium amorphe hydrogéné de l'empilement (4) est comprise entre 5 et 50 nanomètres.

6. Revêtement selon l'une quelconque des revendications 1 à 5, **caractérisé en ce que** l'épaisseur de chacune des couches (4a) en carbone amorphe hydrogéné de l'empilement (4) est comprise entre 10 et 150 nanomètres.

7. Revêtement selon l'une quelconque des revendications 1 à 6, **caractérisé en ce que** le nombre de couches (4a, 4b) dans l'empilement (4) est compris entre 400 et 1000.

8. Procédé de dépôt d'un revêtement pour une pièce mécanique (2) selon l'une quelconque des revendications 1 à 7, **caractérisé en ce qu'**il consiste à déposer, successivement, dans une même enceinte de dépôt chimique en phase vapeur assisté par plasma:
- une première couche (3) en carbure de silicium amorphe hydrogéné,
- une alternance de couches (4a, 4b) respectivement en carbone amorphe hydrogéné et en carbure de silicium amorphe hydrogéné,
- et une couche externe (5) en carbone amorphe hydrogéné.

9. Procédé de dépôt selon la revendication 8, **caractérisé en ce que** la pression dans l'enceinte, lors du dépôt des couches, est comprise entre 0,05mBar et 0,5mBar.

10. Procédé de dépôt selon l'une des revendications 8 et 9, **caractérisé en ce que** la pièce mécanique (2) est préalablement nettoyée et subit un décapage ionique.

## Claims

1. Coating for a mechanical part comprising at least one external layer (5) of hydrogenated amorphous carbon, **characterized in that** the coating (1) is formed by a first layer (3) of hydrogenated amorphous silicon carbide designed to be in contact with the mechanical part (2), a stack (4) being consisted of an alternation of layers (4a, 4b) respectively of hydrogenated amorphous carbon and hydrogenated amorphous silicon carbide being arranged between the first layer (3) and the external layer (5).

2. Coating according to claim 1, **characterized in that** the total thickness of the coating (1) is comprised between 10 and 20 micrometers.

3. Coating according to one of the claims 1 and 2, **characterized in that** the thickness of the first layer (3) is comprised between 150 and 300 nanometers.

4. Coating according to any one of the claims 1 to 3, **characterized in that** the thickness of the external layer (5) is comprised between 0.5 and 2 micrometers.

5. Coating according to any one of the claims 1 to 4, **characterized in that** the thickness of each of the layers (4b) of hydrogenated amorphous silicon carbide of the stack (4) is comprised between 5 and 50 nanometers.

6. Coating according to any one of the claims 1 to 5, **characterized in that** the thickness of each of the layers (4a) of hydrogenated amorphous carbon of the stack (4) is comprised between 10 and 150 nanometers.

7. Coating according to any one of the claims 1 to 6, **characterized in that** the number of layers (4a, 4b) in the stack (4) is comprised between 400 and 1000.

8. Method of depositing a coating for a mechanical part (2) according to any one of the claims 1 to 7, **characterized in that** it consists in depositing, successively, in a same plasma enhanced chemical vapour deposition enclosure:
- a first layer (3) of hydrogenated amorphous silicon carbide,
- an alternation of layers (4a, 4b) respectively of hydrogenated amorphous carbon and hydrogenated amorphous silicon carbide,
- and an external layer (5) of hydrogenated amorphous carbon.

9. Method of depositing according to claim 8, **characterized in that** the pressure in the enclosure, when deposition of the layers is performed, is comprised between 0.05mBar and 0.5mBar.

10. Method of depositing according to one of the claims 8 and 9, **characterized in that** the mechanical part (2) is previously cleaned and is subjected to an ionic stripping.

## Patentansprüche

1. Überzug für ein mechanisches Teil mit mindestens einer Außenschicht (5) aus hydriertem amorphem Kohlenstoff,
**dadurch gekennzeichnet,**
**dass** der Überzug (1) eine erste Schicht (3) aus hydriertem amorphem Siliciumcarbid enthält, die dazu bestimmt ist, mit dem mechanischen Teil (2) in Kontakt zu sein, wobei eine Aufeinanderschichtung von sich abwechselnden Schichten (4a, 4b) aus hydriertem amorphem Kohlenstoff bzw. hydriertem amorphem Siliciumcarbid zwischen der ersten Schicht (3) und der Außenschicht (5) angeordnet ist.

2. Überzug nach Anspruch 1,
**dadurch gekennzeichnet,**
**dass** die Gesamtstärke des Überzugs (1) zwischen 10 und 20 Mikrometer beträgt.

3. Überzug nach einem der Ansprüche 1 und 2,
**dadurch gekennzeichnet,**
**dass** die Stärke der ersten Schicht (3) zwischen 150 und 300 Nanometer beträgt.

4. Überzug nach einem der Ansprüche 1 bis 3,
**dadurch gekennzeichnet,**
**dass** die Stärke der Außenschicht (5) zwischen 0,5 und 2 Mikrometer beträgt.

5. Überzug nach einem der Ansprüche 1 bis 4,
**dadurch gekennzeichnet,**
**dass** die Stärke jeder der Schichten (4b) aus hydriertem amorphem Siliciumcarbid der Aufeinanderschichtung (4) zwischen 5 und 50 Nanometer beträgt.

6. Überzug nach einem der Ansprüche 1 bis 5,
**dadurch gekennzeichnet,**
**dass** die Stärke jeder der Schichten (4a) aus hydriertem amorphem Kohlenstoff der Aufeinanderschichtung (4) zwischen 10 und 150 Nanometer beträgt.

7. Überzug nach einem der Ansprüche 1 bis 6,
**dadurch gekennzeichnet,**
**dass** die Anzahl von Schichten (4a, 4b) in der Aufeinanderschichtung (4) zwischen 400 und 1000 beträgt.

8. Verfahren zum Auftragen eines Überzugs für ein mechanisches Teil (2) nach einem der Ansprüche 1 bis 7,
**dadurch gekennzeichnet,**
**dass** es darin besteht, in einem und demselben abgeschlossenen Raum zum plasmagestützten chemischen Auftragen in Dampfphase nacheinander aufzutragen:
- eine erste Schicht (3) aus hydriertem amorphem Siliciumcarbid,
- abwechselnd Schichten (4a, 4b) aus hydriertem amorphem Kohlenstoff bzw. hydriertem amorphem Siliciumcarbid,
- und eine Außenschicht (5) aus hydriertem amorphem Kohlenstoff.

9. Verfahren zum Auftragen nach Anspruch 8,
**dadurch gekennzeichnet,**
**dass** der Druck in dem abgeschlossenen Raum beim Auftragen der Schichten zwischen 0,05 mBar und 0,5 mBar beträgt.

10. Verfahren zum Auftragen nach einem der Ansprüche 8 und 9,
**dadurch gekennzeichnet,**
**dass** das mechanische Teil (2) zuvor gereinigt wird und einem Ionen-Beizen unterzogen wird.
